# FASCICULE DE BREVET EUROPEEN

(11) **EP 0 431 106 B1**
(45) Date de publication et mention de la délivrance du brevet: **26.06.1996**
(21) Numéro de dépôt: 90908551.6
(22) Date de dépôt: 22.05.1990
(51) Int. Cl.: H01L 23/498, H01L 23/538

(54) **CIRCUIT ELECTRONIQUE EN BOITIER AVEC PUCE SUR ZONE QUADRILLEE DE PLOTS CONDUCTEURS**
VERKAPSELTE ELEKTRONISCHE SCHALTUNG MIT CHIP AUF EINER QUADRIERTEN ZONE MIT LEITERPODESTEN
PACKAGED ELECTRONIC CIRCUIT WITH A CHIP ON A GRIDDED AREA OF CONDUCTIVE PADS

(30) Priorité: 30.05.1989 FR 8907091
(43) Date de publication de la demande: 12.06.1991
(73) Titulaire: THOMSON-CSF SEMICONDUCTEURS SPECIFIQUES, 75008 Paris (FR)
(72) Inventeur: MABBOUX, Henri, F-38950 Saint-Martin-le-Vinoux (FR); MERMET-GUYENNET, Michel, F-38120 Saint-Egrève (FR)
(74) Mandataire: Guérin, Michel
(86) Numéro de dépôt international: FR9000360
(87) Numéro de publication internationale: WO9015439

(56) Documents cités:
- EP-A- 0 116 119
- EP-A- 0 312 975
- FR-A- 2 557 366
- PATENT ABSTRACTS OF JAPAN, Vol. 7, No. 233 (E-204)(1378), 15 Octobre 1983; &JP-A-58122753

## Description

L'invention concerne les boîtiers d'encapsulation de circuits-intégrés. Elle est applicable tout particulièrement aux boîtiers céramiques multicouches et sera décrite plus en détail à propos d'un tel type de boîtier bien qu'on puisse aussi envisager son application à d'autres types de boîtier.

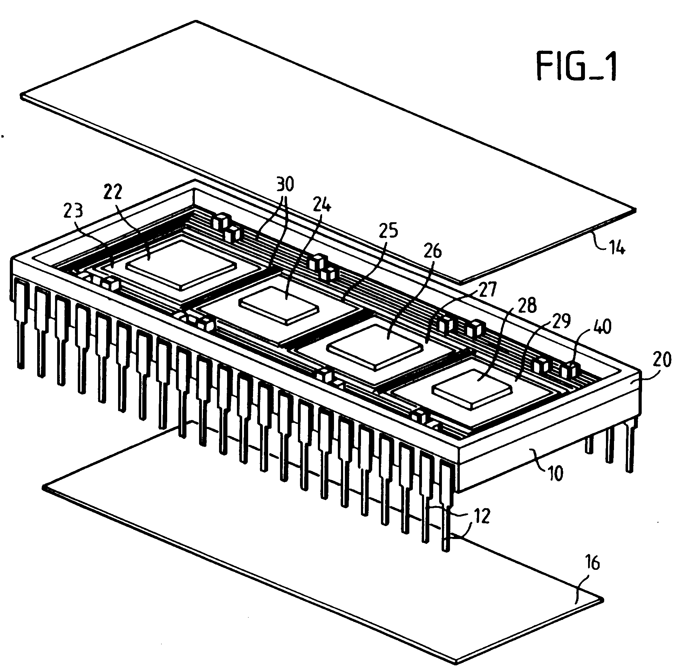

Un boîtier céramique multicouche est représenté à titre d'exemple à la figure 1. C'est un boîtier destiné à recevoir plusieurs puces de circuit-intégré; ces puces sont montées sur un substrat de céramique 10 sur lequel sont soudées des broches de connexion extérieures 12; le boîtier est fermé par un capot supérieur 14 et un capot inférieur 16. Le substrat peut porter des puces sur le dessus et des puces sur le dessous. Les puces du dessus sont logées dans une cavité dont le fond est constitué par la face supérieure du substrat, et les bords sont constitués par un anneau 20 qui, dans cet exemple, est un anneau métallique (en alliage fer-cobalt-nickel par exemple).

Dans l'exemple représenté, le boîtier peut comporter jusqu'à quatre puces de circuit-intégré 22, 24, 26, 28 sur la face supérieure, des emplacements 23, 25, 27, 29 étant réservés respectivement à chacune des puces. Des puces sont également prévues sur des emplacements respectifs de la face inférieure du substrat; elles n'ont pas été représentées.

Des conducteurs 30 sont sérigraphiés sur la face inférieure et sur la face supérieure du substrat; des conducteurs sont également sérigraphiés sur les couches internes du substrat puisqu'un substrat de céramique multicouche est constitué par un empilement de feuilles de céramique sérigraphiées cocuites. Des condensateurs 40 (pour le découplage des alimentations) peuvent être soudés directement sur les conducteurs de la surface du substrat.

Un des buts de l'invention est de réaliser un boîtier qui puisse recevoir des puces de taule variable sur les emplacements réservés. En effet, on souhaite qu'un même boîtier puisse servir à plusieurs applications différentes, c'est-à-dire à des circuits électroniques à plusieurs puces dont les puces peuvent différer non seulement dans leur fonctionalité, mais aussi dans leur taille et leur nombre de plots d'entrée/sortie.

Une des raisons qu'on a de vouloir des boîtiers adaptables à plusieurs applications est le gain de temps qu'on peut obtenir si on n'a pas à reconcevoir et à refabriquer un nouveau boîtier pour chaque application; la conception d'un nouveau boîtier, la fabrication de l'outillage de découpe de feuilles de céramique crue, de perçage de ces feuilles, la fabrication des outils de sérigraphie, la réalisation des feuilles de céramique crue et leur sérigraphie, la cuisson, le montage des puces et le test prennent en effet plusieurs mois et il serait souhaitable de supprimer une bonne partie de ce délai.

Malheureusement, on s'est aperçu qu'il y avait une difficulté pour adapter des puces de taille différente sur un emplacement réservé. L'emplacement réservé est une zone sur laquelle on peut coller ou souder une puce. La taille maximale de puce que l'on peut mettre sur cet emplacement est évidemment directement liée à la taille de l'emplacement. Cet emplacement est entouré de plages conductrices de connexion sur lesquelles on peut venir souder des fils de liaison avec la puce selon la technique classique dite "wire-bonding" (de l'anglais soudure par fils). Ces plages conductrices sont sérigraphiées sur le substrat et sont reliées à des conducteurs sérigraphiés sur les faces du substrat ou dans les couches internes de celui-ci.

Si la puce qu'on place sur l'emplacement réservé a une taille maximale, il n'y a pas de problème pour souder des fils de liaison entre la puce et les plages conductrices de connexion.

Mais si la puce est plus petite, et tout particulièrement si elle est très petite par rapport à l'emplacement, on est obligé d'utiliser des fils de liaison assez longs entre la puce et les plages conductrices. Or les fils longs sont plus fragiles ; d'autre part ils ne sont pas rigides (par leur nature même) ; plus ils sont longs plus ils sont sensibles à des vibrations, et leur tenue mécanique aux accélérations n'est pas bonne. Il y a notamment un risque non négligeable de court-circuit entre deux fils voisins sujets à des vibrations (les fils sont des fils d'or ou d'aluminium non isolés).

La demande de brevet EP-A-031975 décrit un circuit électronique selon la première partie de la revendication 1 comprenant un boîtier d'encapsulation adaptable à plusieurs puces différentes. Les plots périphériques sont utilisés sélectivement en fonction de la puce à monter.

La présente invention a pour but de proposer un moyen pour permettre de placer des puces de taille variable sur un emplacement de taille fixe sans rencontrer l'inconvénient qui vient d'être mentionné.

Selon l'invention on propose un circuit électronique encapsulé dans un boîtier selon la revendication 1 qui, en résumé, comporte un emplacement de réception de puce monolithique, cet emplacement comportant un réseau de nombreux plots conducteurs isolés électriquement les uns des autres disposés de telle manière que d'une part la puce peut être collée ou soudée sur ces plots si elle a une taille maximale autorisée par la surface de l'emplacement, et d'autre part des plots entourent la puce si elle a une taille inférieure à cette taille maximale. Ces plots sont des plots servant de relais de soudure ; ils sont en un matériau compatible avec la soudure utilisée dans les liaisons entre les puces et le boîtier.

En principe, l'emplacement réservé à la puce monolithique est entouré de plages conductrices de connexion et des plots isolés les uns des autres seront formés (normalement par sérigraphie) entre la puce et les plages conductrices.

Des fils de liaison entre la puce et les plages conductrices pourront alors être soudés soit directement entre la puce et la plages conductrices si la distance est faible, soit entre la puce et un plot isolé d'où repartira le fil vers un plot ou vers la plage conductrice.

Chaque plot est alors susceptible de former un emplacement intermédiaire de relais pour un fil de liaison allant de la puce vers une plage conductrice. Les plots sont donc réalisés dans une matière permettant une telle soudure et le mieux est de les réaliser dans le même matériau que les plages conductrices (alliage de tungstène, nickel, or par exemple); ils sont réalisés en partie lors de la sérigraphie des feuilles de céramique crue et font partie du motif de conducteurs sérigraphiés sur les couches superficielles (inférieure et supérieure) du substrat 10.

On peut prévoir que les plots sont répartis sur toute la surface de l'emplacement réservé à la puce; ils peuvent être aussi répartis seulement sur le pourtour de cet emplacement, la partie centrale de l'emplacement pouvant être dépourvue totalement de couche conductrice ou pouvant être recouverte d'une couche conductrice uniforme correspondant par exemple à une taille de petite puce ou une taille intermédiaire.

L'invention est particulièrement utile dans le cas où on souhaitera que certains fils de liaison soient directement tirés entre la puce et des conducteurs sérigraphiés moins proches de la puce que ne le sont les plages conductrices qui entourent l'emplacement réservé à la puce.

D'autres caractéristiques et avantages de l'invention apparaîtront à la lecture de la description détaillée qui suit et qui est faite en référence aux dessins annexés dans lesquels :
- la figure 1 représente une structure générale de boîtier céramique multicouche à laquelle peut s'appliquer l'invention;
- la figure 2 représente une vue de la face supérieure du substrat avec des emplacement de réception de puces selon l'invention ;
- la figure 3 représente une vue de la face supérieure du substrat avec des puces mises en place dans les emplacements réservés;
- la figure 4 représente schématiquement des variantes de réalisation de l'invention.

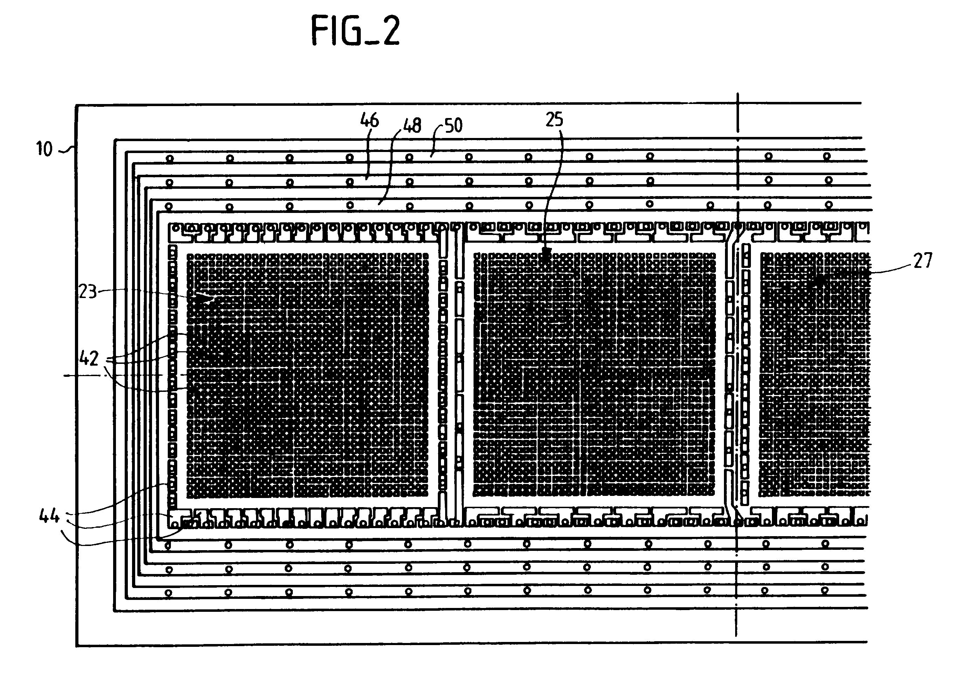

Sur la figure 2 qui illustre un mode de réalisation de l'invention, on voit la face supérieure du substrat de céramique 10, avec trois emplacements 23, 25, 27 réservés chacun à une puce respective. Les références de la figure 1 sont reprises dans les figures suivantes si elles désignent les mêmes éléments.

Dans le mode de réalisation représenté, la totalité de la surface réservée à la puce sur chaque emplacement est recouverte de nombreux plots conducteurs 42 isolés les uns des autres; ils sont réalisés par sérigraphie en même temps que les autres conducteurs qui peuvent être présents sur la même surface de céramique.

Ici la surface sur laquelle sont sérigraphiés les plots conducteurs est la surface de la couche supérieure de céramique du substrat, mais dans d'autres cas ce pourrait être une surface de couche intermédiaire apparente : c'est le cas lorsque la surface supérieure présente une découpe servant de logement à la puce, la puce étant collée dans le fond de ce logement donc sur une couche inférieure de céramique sérigraphiée.

Les plots 42 sont par exemple des plots de forme rectangulaire ou carrée; leur surface est suffisante pour qu'on puisse y souder un fil de liaison par la technique de "wire-bonding". Mais elle est suffisamment petite pour que de nombreux plots puissent être répartis autour de la puce et servir de relais de soudure pour un ou plusieurs ou tous les fils de liaison entre les puces et le substrat. Les plots sont de préférence distribués uniformément sur la surface qu'ils occupent.

La surface recouverte de plots est destinée à recevoir une puce collée ou soudée, de taille variable. Si une puce de taille maximale est mise en place, les plots sont pratiquement tous recouverts par la puce.

L'emplacement réservé à la soudure ou au collage d'une puce monolithique est entouré de plages conductrices de connexion 44. Ces plages conductrices sérigraphiées sont destinées à constituer des emplacements de soudure de fils de liaison dont le rôle est de relier les conducteurs du substrat avec la puce qui viendra sur cet emplacement. La taille maximale des puces qui peuvent être mises en place est définie par la surface délimitée par les plages conductrices, à laquelle il faut retrancher une bande périphérique de garde telle que la puce ne risque pas d'être trop près des plages conductrices 44.

Le nombre de plages conductrices 44 correspond à peu près ou exactement au nombre de plots maximal que peuvent comporter les puces destinées à venir sur les emplacements réservés. Si une puce ayant un nombre de plots d'entrée/sortie plus faible que le nombre maximal est utilisée, certaines plages conductrices ne seront pas utilisées.

Dans l'exemple de réalisation qui est décrit ici, les plots d'entrée/sortie de la puce sont décomposés en plots d'alimentation en énergie et plots de cheminement de signaux, et les plots d'alimentation en énergie sont traités différemment des autres : les plages conductrices situées autour des emplacements réservés au puce ne servent que pour les signaux et pas pour les alimentations en énergie. Pour l'alimentation en énergie, des conducteurs sérigraphiés 46, 48, 50 font le tour des emplacements réservés aux puces en longeant la périphérie du substrat, de manière que ces conducteurs passent à proximité de chacune des puces.

Les conducteurs d'alimentation en énergie 46, 48, 50 (par exemple un conducteur de masse et deux potentiels d'alimentation) passent autour des plages conductrices 44; ils sont donc plus loin des puces que les plages conductrices 44, mais ils sont quand même assez proches pour que des fils de liaison puissent être soudés directement entre la puce (si elle est de grande taille) et ces conducteurs, sans passer par des plages conductrices 44 et des conducteurs sérigraphiés qui rejoindraient les conducteurs périphériques d'alimentation 46, 48, 50.

Sur la figure 2 on a encore représenté par des points ou petits cercles des vias conducteurs permettant de relier entre eux les conducteurs sérigraphiés des différentes couches de céramique.

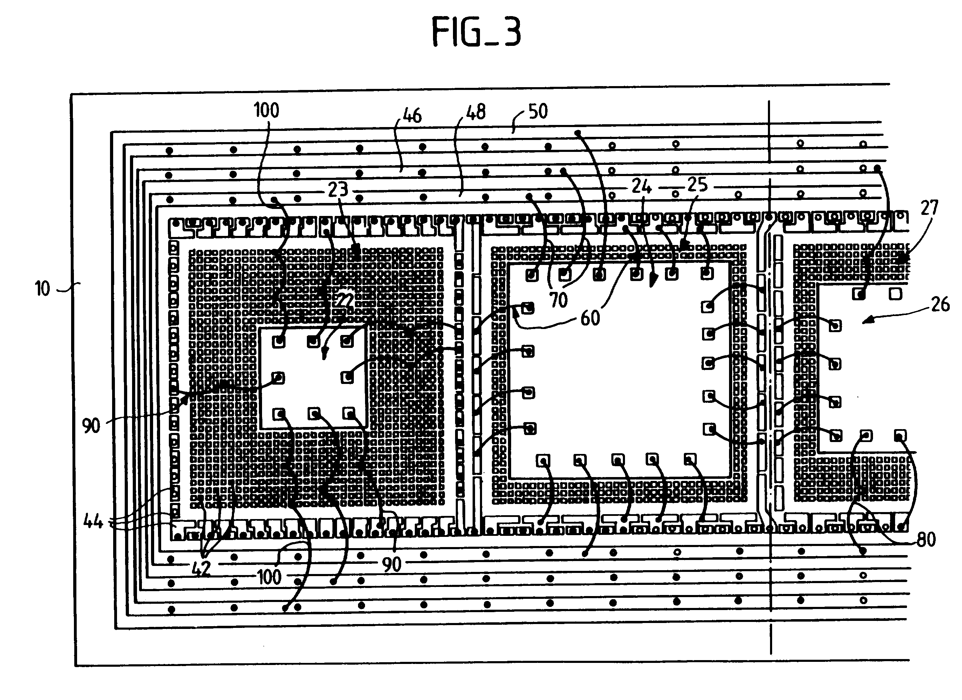

Sur la figure 3 on a représenté le même substrat qu'à la figure 2, avec des puces mises en place sur les emplacements 23, 25, et 27.

Pour mieux faire apparaître l'intérêt de l'invention, on a représenté une puce 22 de petite taille sur l'emplacement 23, une puce 24 de grande taille sur l'emplacement 25, et une puce 26 de taille moyenne sur l'emplacement 27.

La puce de grande taille 24 est collée ou soudée sur l'emplacement 25 donc sur les plots conducteurs isolés déposés en réseau sur cet emplacement. Elle recouvre la majeure partie de ces plots. Des fils de liaison 60 sont soudés classiquement entre la puce et les plages conductrices 44 qui entourent l'emplacement 25. Certains fils 70 sont soudés directement entre la puce et les conducteurs périphériques 46, 48, 50; ce sont les fils correspondant à l'alimentation en énergie de la puce.

Pour la puce de taille moyenne 26, il reste possible de souder des fils de liaison entre les plots de la puce et les plages conductrices 44 qui entourent l'emplacement 27. Mais il devient impossible ou dangereux de souder des fils directement de la puce vers les conducteurs périphériques d'alimentation. On utilise donc pour l'alimentation de la puce les plots conducteurs selon l'invention. Ils servent de relais pour un fil 80 qui va de la puce au plot et qui repart du plot vers le conducteur périphérique désiré. L'invention est donc intéressante puisqu'elle rend plus facile l'utilisation d'une configuration dans laquelle les conducteurs d'alimentation, traités à part, entourent les plages conductrices réservées au cheminement de signaux.

Pour la puce de petite taille 22, sur l'emplacement 23, l'invention est encore plus intéressante. En effet, dans ce cas, la taille de la puce par rapport à l'emplacement est telle qu'il devient difficile ou impossible de souder des fils entre la puce et les plages conductrices 44. On utilise donc pour chaque fil de liaison 90 un plot relais entre la puce et la plage conductrice. Et a fortiori il est impossible de relier directement un fil de la puce à un conducteur périphérique d'alimentation. On utilise donc également des plots relais pour ces liaisons; on peut même, comme cela est représenté pour les fils 100 utiliser deux plots relais pour chaque fil, afin de se rapprocher le plus possible de la périphérie de l'emplacement réservé à la puce avant de franchir l'espace qui le sépare des conducteurs périphériques 46, 48, 50.

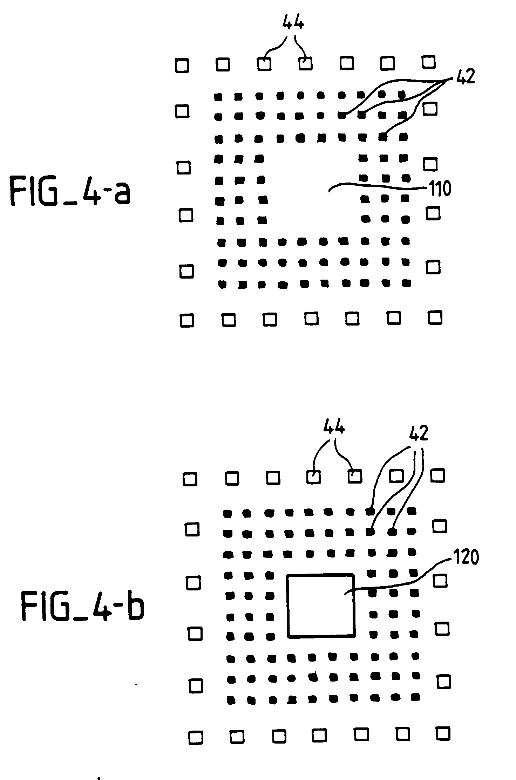

A la figure 4 ,on a représenté deux variantes de réalisation de l'invention. Dans ces deux variantes la surface centrale de l'emplacement réservé à la puce n'est pas recouverte de plots conducteurs isolés. Cette surface centrale correspond en gros à la surface de la plus petite puce qu'on envisage de mettre dans le boîtier. Dans la variante de la figure 4a, cette surface centrale 110 est laissée dénudée : c'est une surface de céramique du substrat. Dans la variante de la figure 4b, cette surface centrale est métallisée (par la même sérigraphie qui permet de réaliser les plots 42, les plages conductrices 44 et les autres conducteurs du substrat) . Cette surface métallisée peut d'ailleurs être reliée par des vias intercouches aux autres conducteurs du substrat, et plus précisément en principe à un conducteur de masse. Cette surface métallisée peut servir de contact de face arrière pour les puces de silicium.

## Revendications

1. Circuit électronique encapsulé dans un boîtier qui comporte au moins un emplacement (23,25,27) de réception de puce monolithique (24, 26, 28), chaque emplacement étant de taille fixe et étant entouré de plages conductrices (44) de connexion, qui sont reliées électriquement par des fils de liaison (80, 90, 100) à ladite puce, caractérisé en ce que chaque emplacement comporte un réseau de nombreux plots conducteurs (42) isolés électriquement les uns des autres et est destiné à recevoir une puce collée ou soudée, de taille variable de telle manière qu'une puce de taille maximale recouvre lesdits plots conducteurs tandis qu'une puce de taille inférieure à cette taille maximale est entourée par certains desdits plots conducteurs, et en ce que les plots conducteurs entourant une puce de taille inférieure sont susceptibles de servir de relais intermédiaire de soudure pour lesdits fils de liaison.

2. Circuit électronique selon la revendication 1, caractérisé en ce que les plots conducteurs sont repartis sur toute la surface de l'emplacement de réception de puce.

3. Circuit électronique selon la revendication 1, caractérisé en ce que les plots conducteurs sont répartis seulement sur le pourtour de l'emplacement de réception de puce, la partie centrale (110) de cet emplacement étant dépourvue totalement de couche conductrice.

4. Circuit électronique selon la revendication 1, caractérisé en ce que les plots conducteurs sont répartis seulement sur le pourtour de l'emplacement de réception de puce, la partie centrale de l'emplacement étant recouverte d'une couche conductrice uniforme (120).

5. Circuit électronique selon la revendication 4, caractérisé en ce que le boîtier est un boîtier céramique multicouche comprenant un substrat de céramique multicouche (10), et en ce que la couche conductrice uniforme (120), réalisée sur une couche de céramique superficielle du substrat, est reliée par des vias à des conducteurs d'une ou plusieurs autres couches de céramique du substrat.

6. Circuit électronique selon l'une des revendications 1 à 4, caractérisé en ce que le boîtier comprend un substrat céramique multicouche sur lequel les puces sont mises en place.

7. Procédé de réalisation d'un circuit électronique selon l'une des revendications 5 ou 6, caractérisé en ce que les plots conducteurs sont réalisés par sérigraphie sur la surface du substrat céramique multicouche.

8. Procédé selon la revendication 7, caractérisé en ce que les plots conducteurs sont realisés simultanément avec les autres conducteurs de ladite surface et avec le même matériau.

## Patentansprüche

1. Elektronische Schaltung, die in ein Gehäuse eingekapselt ist, welches mindestens einen Platz (23, 25, 27) für einen monolithischen Chip (24, 26, 28) aufweist, wobei jeder Platz eine konstante Größe besitzt und von leitenden Anschlußbereichen (44) umgeben ist, die elektrisch über Verbindungsdrähte (80, 90, 100) mit dem Chip verbunden sind, dadurch gekennzeichnet, daß jeder Platz ein Netz von zahlreichen leitenden und elektrisch gegeneinander isolierten Lötpunkten (42) besitzt und durch Kleben oder Löten einen Chip variabler Größe aufnehmen kann, so daß ein Chip maximaler Größe die leitenden Lötpunkte bedeckt, während ein kleinerer Chip von manchen dieser leitenden Lötpunkte umgeben ist, und daß die leitenden Lötpunkte, die einen kleineren Chip umgeben, als Zwischenstützpunkte zum Anlöten oder Anschweißen der Verbindungsdrähte dienen.

2. Elektronische Schaltung nach Anspruch 1, dadurch gekennzeichnet, daß die leitenden Lötpunkte über die ganze Oberfläche des Platzes für einen Chip verteilt sind.

3. Elektronische Schaltung nach Anspruch 1, dadurch gekennzeichnet, daß die leitenden Lötpunkte nur über den Umfang des Platzes für einen Chip verteilt sind, während der zentrale Bereich (110) dieses Platzes ohne jede leitende Beschichtung ist.

4. Elektronische Schaltung nach Anspruch 1, dadurch gekennzeichnet, daß die leitenden Lötpunkte nur über den Umfang des Platzes für den Chip verteilt sind, während der zentrale Bereich des Platzes mit einer gleichförmigen leitenden Beschichtung (120) bedeckt ist.

5. Elektronische Schaltung nach Anspruch 4, dadurch gekennzeichnet, daß das Gehäuse ein keramisches Mehrschichtengehäuse ist, das ein keramisches Mehrschichtensubstrat (10) enthält, und daß die gleichförmige leitende Schicht (120), die auf einer oberflächlichen Keramikschicht des Substrats ausgebildet ist, über leitende Wege mit Leitern einer oder mehrerer anderer Keramikschichten des Substrats verbunden ist.

6. Elektronische Schaltung nach einem der Ansprüche 1 bis 4, dadurch gekennzeichnet, daß das Gehäuse ein keramisches Mehrschichtsubstrat enthält, auf dem die Chips angeordnet sind.

7. Verfahren zur Herstellung einer elektronischen Schaltung nach einem der Ansprüche 5 oder 6, dadurch gekennzeichnet, daß die leitenden Lötpunkte serigraphisch auf die Oberfläche des keramischen Mehrschichtsubstrats aufgedruckt sind.

8. Verfahren nach Anspruch 7, dadurch gekennzeichnet, daß die leitenden Lötpunkte gleichzeitig mit den anderen Leitern auf dieser Fläche und aus demselben Material hergestellt sind.

## Claims

1. Electronic circuit encapsulated in a case which comprises at least one site (23, 25, 27) for receiving a monolithic chip (24, 26, 28), each site being of fixed size and being surrounded by conductive connection regions (44) which are electrically connected to the said chip by connection wires (80, 90, 100), characterized in that each site comprises an array of several mutually electrically insulated conductive pads (42), and is intended to receive a bonded or soldered chip, of variable size such that a chip of maximum size covers the said conductive pads, whereas a chip of size smaller than this maximum size is surrounded by some of the said conductive pads, and in that the conductive pads surrounding a chip of smaller size can act as intermediate soldering relay for the said connection wires.

2. Electronic circuit according to Claim 1, characterized in that the conductive pads are distributed over the whole area of the chip-reception site.

3. Electronic circuit according to Claim 1, characterized in that the conductive pads are distributed only over the periphery of the chip-reception site, the central portion (110) of this site being totally devoid of conductive layer.

4. Electronic circuit according to Claim 1, characterized in that the conductive pads are distributed only over the periphery of the chip-reception site, the central portion of the site being covered with a uniform conductive layer (120).

5. Electronic circuit according to Claim 4, characterized in that the case is a multi-layer ceramic case comprising a multi-layer ceramic substrate (10), and in that the uniform conductive layer (120), made on a surface ceramic layer of the substrate, is connected by vias to conductors of one or more other ceramic layers of the substrate.

6. Electronic circuit according to one of Claims 1 to 4, characterized in that the case comprises a multi-layer ceramic substrate on which the chips are fitted.

7. Method of producing an electronic circuit according to one of Claims 5 or 6, characterized in that the conductive pads are made by silk-screen printing on the surface of the multi-layer ceramic substrate.

8. Method according to Claim 7, characterized in that the conductive pads are made at the same time as the other conductors of the said surface and with the same material.
